# EUROPEAN PATENT APPLICATION

(11) **EP 3 843 097 A1**
(43) Date of publication of application: **30.06.2021**
(21) Application number: 20194491.5
(22) Date of filing: 04.09.2020
(51) Int. Cl.: G11C 5/02, G11C 11/4096, G11C 11/4097

(54) **HIGH BANDWIDTH DRAM MEMORY WITH WIDE PREFETCH**

(30) Priority: 23.12.2019 US 201916726029
(71) Applicant: Intel Corporation, Santa Clara, CA 95054 (US)
(72) Inventor: TOMISHIMA, Shigeki, Santa Clara, CA 95054 (US)
(74) Representative: Rummler, Felix

(57) **Abstract**

An embodiment of an electronic apparatus may include a silicon substrate and a memory circuit coupled to the silicon substrate, the memory circuit including an array block of memory tiles coupled to the silicon substrate, a first set of global amplifiers coupled to the silicon substrate and the memory tiles and arranged along a first side of the array block, a first set of write drivers coupled to the silicon substrate and coupled to the memory tiles and arranged along the first side of the array block, a second set of global amplifiers coupled to the silicon substrate and coupled to the memory tiles and arranged along a second side of the array block opposite to the first side of the array block, and a second set of write drivers coupled to the silicon substrate and coupled to the memory tiles and arranged along the second side of the array block. Other embodiments are disclosed and claimed.

## Description

### BACKGROUND

Standards for a high bandwidth memory (HBM) dynamic random access memory (DRAM) interface are published by JEDEC (www.jedec.org). Updates to these standards include HBM2 and HMB2E. HBM technology provides higher bandwidth at lower power consumption as compared to some other memory technologies. HBM technology may include stacks of memory dice and a much wider memory bus as compared to some other memory technologies.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 is a block diagram of an example of a memory apparatus according to an embodiment;
FIG. 2 is a block diagram of an example of an electronic apparatus according to an embodiment;
FIG. 3A is a block diagram of an example of an array block according to an embodiment;
FIG. 3B is a more detailed block diagram of an example of a memory tile from an array block according to an embodiment;
FIG. 4 is a block diagram of an example of a wide prefetch memory device according to an embodiment;
FIGs. 5A to 5B are front view and top view block diagrams, respectively, of an example of an electronic apparatus according to an embodiment; and
FIG. 6 is a block diagram of an example of a computing system according to an embodiment.

### DETAILED DESCRIPTION

One or more embodiments or implementations are now described with reference to the enclosed figures. While specific configurations and arrangements are discussed, it should be understood that this is done for illustrative purposes only. Persons skilled in the relevant art will recognize that other configurations and arrangements may be employed without departing from the spirit and scope of the description. It will be apparent to those skilled in the relevant art that techniques and/or arrangements described herein may also be employed in a variety of other systems and applications other than what is described herein.

While the following description sets forth various implementations that may be manifested in architectures such as system-on-a-chip (SoC) architectures for example, implementation of the techniques and/or arrangements described herein are not restricted to particular architectures and/or computing systems and may be implemented by any architecture and/or computing system for similar purposes. For instance, various architectures employing, for example, multiple integrated circuit (IC) chips and/or packages, and/or various computing devices and/or consumer electronic (CE) devices such as set top boxes, smartphones, etc., may implement the techniques and/or arrangements described herein. Further, while the following description may set forth numerous specific details such as logic implementations, types and interrelationships of system components, logic partitioning/integration choices, etc., claimed subject matter may be practiced without such specific details. In other instances, some material such as, for example, control structures and full software instruction sequences, may not be shown in detail in order not to obscure the material disclosed herein.

The material disclosed herein may be implemented in hardware, firmware, software, or any combination thereof. The material disclosed herein may also be implemented as instructions stored on a machine-readable medium, which may be read and executed by one or more processors. A machine-readable medium may include any medium and/or mechanism for storing or transmitting information in a form readable by a machine (e.g., a computing device). For example, a machine-readable medium may include read only memory (ROM); random access memory (RAM); magnetic disk storage media; optical storage media; flash memory devices; electrical, optical, acoustical or other forms of propagated signals (e.g., carrier waves, infrared signals, digital signals, etc.), and others.

References in the specification to "one implementation", "an implementation", "an example implementation", etc., indicate that the implementation described may include a particular feature, structure, or characteristic, but every embodiment may not necessarily include the particular feature, structure, or characteristic. Moreover, such phrases are not necessarily referring to the same implementation. Further, when a particular feature, structure, or characteristic is described in connection with an embodiment, it is submitted that it is within the knowledge of one skilled in the art to effect such feature, structure, or characteristic in connection with other implementations whether or not explicitly described herein.

Methods, devices, systems, and articles are described herein related to storage systems. More particularly, some embodiments relate to an improved dynamic single level cell memory controller.

Various embodiments described herein may include a memory component and/or an interface to a memory component. Such memory components may include volatile and/or nonvolatile (NV) memory. Volatile memory may be a storage medium that requires power to maintain the state of data stored by the medium. Non-limiting examples of volatile memory may include various types of RAM, such as DRAM or static RAM (SRAM). One particular type of DRAM that may be used in a memory module is synchronous dynamic RAM (SDRAM). In particular embodiments, DRAM of a memory component may comply with a standard promulgated by Joint Electron Device Engineering Council (JEDEC), such as JESD79F for double data rate (DDR) SDRAM, JESD79-2F for DDR2 SDRAM, JESD79-3F for DDR3 SDRAM, JESD79-4A for DDR4 SDRAM, JESD209 for Low Power DDR (LPDDR), JESD209-2 for LPDDR2, JESD209-3 for LPDDR3, and JESD209-4 for LPDDR4 (these standards are available atjedec.org). Such standards (and similar standards) may be referred to as DDR-based standards and communication interfaces of the storage devices that implement such standards may be referred to as DDR-based interfaces.

NV memory (NVM) may be a storage medium that does not require power to maintain the state of data stored by the medium. In one embodiment, the memory device may include a block addressable memory device, such as those based on NAND or NOR technologies. A memory device may also include future generation nonvolatile devices, such as a three dimensional (3D) crosspoint memory device, or other byte addressable write-in-place nonvolatile memory devices. In one embodiment, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor RAM (FeTRAM), anti-ferroelectric memory, magnetoresistive RAM (MRAM) memory that incorporates memristor technology, resistive memory including the metal oxide base, the oxygen vacancy base and the conductive bridge RAM (CB-RAM), or spin transfer torque (STT)-MRAM, a spintronic magnetic junction memory based device, a magnetic tunneling junction (MTJ) based device, a DW (Domain Wall) and SOT (Spin Orbit Transfer) based device, a thyristor based memory device, or a combination of any of the above, or other memory. The memory device may refer to the die itself and/or to a packaged memory product. In particular embodiments, a memory component with non-volatile memory may comply with one or more standards promulgated by the JEDEC, such as JESD218, JESD219, JESD220-1, JESD223B, JESD223-1, or other suitable standard (the JEDEC standards cited herein are available atjedec.org).

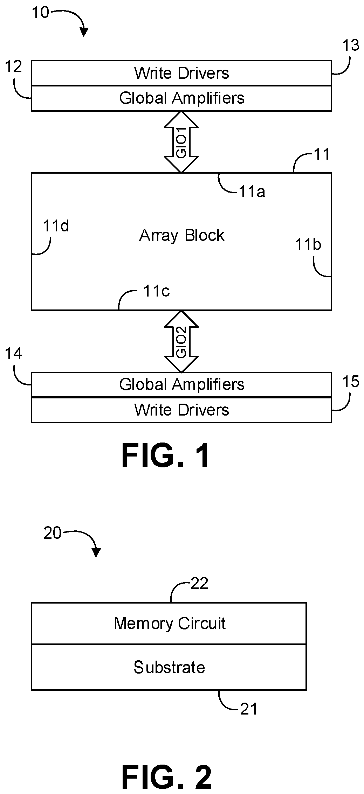

With reference to FIG. 1, an embodiment of a memory apparatus 10 may include an array block 11 of memory tiles, a first set of global amplifiers 12 coupled to the memory tiles of the array block 11 and arranged along a first side 11a of the array block 11, and a second set of global amplifiers 14 coupled to the memory tiles of the array block 11 and arranged along a second side 11c of the array block 11 opposite to the first side 11a of the array block 11. Some embodiments of the apparatus 10 may further include a first set of write drivers 13 coupled to the memory tiles of the array block 11 and arranged along the first side 11a of the array block 11, and a second set of write drivers 15 coupled to the memory tiles of the array block 11 and arranged along the second side 11c of the array block 11. For example, the array block 11 may have a general rectangular shape with four nominal sides 11a, 11b, 11c, and 11d, which corresponds to an outline of memory tiles of the array block with a matrix arrangement aligned in two nominal directions which are perpendicular to each other (e.g., sometimes referred to as rows and columns, x and y, slices and tiles, etc.). Any orientation (top, bottom, row, column, etc.) or order (first, second, etc.) described herein is nominal and dependent on the particular memory implementation and orientation. For example, in another embodiment the first sets of global amplifiers 12 and write drivers 13 may be arranged along the side 11c with the opposed second sets of global amplifiers 14 and write drivers 15 arranged along the side 11a. In another non-limiting example embodiment, the global amplifiers 12 and write drivers 13 may be arranged along the side 11d with the opposed global amplifiers 14 and write drivers 15 arranged along the side 11b.

In some embodiments, the memory apparatus 10 further includes a first set of global input/output (10) signals GIO1 arranged from memory tiles along the second side 11c of the array block 11 to the first set of global amplifiers 12, and a second set of global IO signals GI02 arranged from memory tiles along the first side 11a of the array block 11 to the second set of global amplifiers 14. For example, a first subset of the first set of global IO signals may be respectively coupled to a first memory tile of the array block 11 and a first subset the first set of global amplifiers 12, and a first subset of the second set of global IO signals may be respectively coupled to the first memory tile of the array block 11 and a first subset of the second set of global amplifiers 14 (e.g., as described in further detail herein). In some embodiments, the array block 11 may comprise an M by N matrix (e.g., where M > 1, and N > 1) arranged in a general rectangular shape with M memory tiles arranged substantially linearly in a first direction by N memory tiles arranged substantially linearly in a second direction substantially perpendicular to the first direction, and wherein the array block 11 provides a large page size (e.g., a page size of P of data when activated by an access command, where P is greater than or equal to 1 kilobyte). For example, the first and second sets of global IO signals may provide a wide prefetch (e.g., a combined prefetch size of W bits, and wherein a ratio of P to W is less than or equal to 8 to 1). In any of the embodiments herein, the memory tiles may comprise random access memory, such as dynamic random access memory.

Embodiments of each of the above array block 11, global amplifiers 12, 14 write drivers 13, 15, global 10, and other system components may be implemented with any suitable memory technology, including hardware, software, or any suitable combination thereof. For example, hardware implementations may include configurable logic such as, for example, programmable logic arrays (PLAs), field programmable gate arrays (FPGAs), complex programmable logic devices (CPLDs), or fixed-functionality logic hardware using circuit technology such as, for example, application specific integrated circuit (ASIC), complementary metal oxide semiconductor (CMOS) or transistor-transistor logic (TTL) technology, or any combination thereof.

In some embodiments, the memory components may be located in, or co-located with, various other components, including a controller (e.g., on a same die). Embodiments of a suitable controller may include a general purpose controller, a special purpose controller, a memory controller, a storage controller, a micro-controller, a general purpose processor, a special purpose processor, a central processor unit (CPU), an execution unit, etc. Alternatively, or additionally, all or portions of the controller may be implemented in one or more modules as a set of logic instructions stored in a machine- or computer-readable storage medium such as random access memory (RAM), read only memory (ROM), programmable ROM (PROM), firmware, flash memory, etc., to be executed by a processor or computing device. For example, computer program code to carry out the operations of the components may be written in any combination of one or more operating system (OS) applicable/appropriate programming languages, including an object-oriented programming language such as PYTHON, PERL, JAVA, SMALLTALK, C++, C# or the like and conventional procedural programming languages, such as the "C" programming language or similar programming languages.

Turning now to FIG. 2, an embodiment of an electronic apparatus 20 may include a silicon substrate 21, and a memory circuit 22 coupled to the silicon substrate 21, the memory circuit 22 including an array block of memory tiles, a first set of global amplifiers coupled to the memory tiles and arranged along a first side of the array block, and a second set of global amplifiers coupled to the memory tiles and arranged along a second side of the array block opposite to the first side of the array block. In some embodiments, the memory circuit 22 also includes a first set of write drivers coupled to the memory tiles and arranged along the first side of the array block, and a second set of write drivers coupled to the memory tiles and arranged along the second side of the array block. The memory circuit 22 may further include a first set of global IO signals arranged on the array from memory tiles along the second side of the array block to the first set of global amplifiers, and a second set of global IO signals arranged on the array from memory tiles along the first side of the array block to the second set of global amplifiers. For example, the memory circuit 22 may further include a first subset of the first set of global IO signals respectively coupled to a first memory tile of the array block and a first subset the first set of global amplifiers, and a first subset of the second set of global IO signals respectively coupled to the first memory tile of the array block and a first subset of the second set of global amplifiers.

In some embodiments, the array block may comprise an M by N matrix (e.g., M > 1; N > 1) arranged in a general rectangular shape with M memory tiles arranged substantially linearly in a first direction by N memory tiles arranged substantially linearly in a second direction substantially perpendicular to the first direction, and where the array block provides a page size of P of data when activated by an access command, where P is greater than or equal to 1 kilobyte. For example, the first and second sets of global IO signals may advantageously provide a combined wide prefetch size of W bits, where a ratio of P to W is less than or equal to 8 to 1. In any of the embodiments herein, the memory tiles may comprise random access memory, such as dynamic random access memory. In some memory devices, multiple embodiments of the apparatus 10 may be coupled to each other utilizing a plurality of through silicon vias (TSVs), as may be utilized in various HBM technologies, for example. Embodiments of the silicon substrate 21, memory circuitry 22, and TSVs may be fabricated utilizing any suitable silicon/memory fabrication techniques.

For example, the electronic apparatus 10 may be implemented on a semiconductor apparatus which includes the silicon substrate 21, with the memory circuit 22 coupled to the silicon substrate 21. In some embodiments, the memory circuit 22 may be at least partly implemented in one or more of memory components on the silicon substrate 21. For example, the memory circuit 22 may include a transistor array and/or other integrated circuit components coupled to the silicon substrate 21 with transistor channel regions that are positioned within the silicon substrate 21. The interface between the memory circuit 22 and the silicon substrate 21may not be an abrupt junction. The memory circuit 22 may also be considered to include an epitaxial layer that is grown on an initial wafer of the silicon substrate 21.

Some embodiments may advantageously provide technology for a wide prefetch (WP) in a DRAM memory for high bandwidth applications. In a conventional DRAM IO architecture, the page size activated by a ROW command is large, such as 1 kilobyte (KB), 2KB, etc. But the prefetch size that the users can bring to the IO drivers to output is small such as 64 bits (b), 128b, etc. (e.g., a P:W ratio of page size to prefetch size is 128:1). With the conventional architecture, in order to increase the memory bandwidth with higher frequency or wider pin counts, the page size needs to be increased or multiple operations need to be performed internally. These approaches, however, bring higher power consumption, larger access delay time, etc.

In a conventional HBM2 DRAM IO architecture and array, after a ROW Activation command, 9Kb (1KB) of information (e.g., including an extra 9^{th} error code correction (ECC) tile) are sensed and latched at sense amplifier (SA) bands. After a READ/WRITE command is issued with the column address, only 8b per tile can be transferred from the sense amplifiers (SAs) through global IO lines to the global amplifier, which is placed after the last row of the array block. Usually, the global IO lines are placed in the gaps between memory tiles. In the traditional architecture, the global IO connection between the SA and the global amplifier/write driver is narrow (e.g., about 8b per tile). This structure may reduce the feasibility of utilizing the higher memory bandwidth and the moderate lower power consumption by DRAM memory chips for some high performance computing (HPC) applications, such as artificial intelligence (AI) applications.

Another approach for higher bandwidth may include a high bandwidth low latency (HBLL) architecture, which may improve the P:W ratio from 128:1 to 16:1 (e.g., about 8 times better). The HBLL architecture may increase the global IO bandwidth between the SA and the global amplifier/write driver. The HBLL Architecture changes the column select line (CSL) decoding method from a vertical direction (e.g., column-based) to a horizontal direction (e.g., row-based) and moves the global IO line routing from the gap region between memory tiles to an "on the array" region. These changes may bring a wider global IO connection (e.g., increased by eight times to 64b per tile).

With increasing demands on memory requirements, further improvement in the P:W ratio is desirable. Advantageously, some embodiments provide technology to further improve the P:W ratio for a high bandwidth WP (HBWP) DRAM device. Some embodiments of a HBWP DRAM architecture may place the global amplifiers and the write drivers at the nominal top and the bottom of the array block (e.g., before the first slice and after the last slice of the memory tile matrix) on both sides with routing double of the global IO line on the array (e.g., 128b per tile for a 1 KB page size). Advantageously, some embodiments may increase the prefetch size two times and improve the P:W ratio to 8:1. For example, some embodiments may provide a prefetch size of 1Kb for a page size of 1KB, which corresponds to a sixteen times (16x) improvement from conventional DRAM architectures (e.g., HBM or HBM2) and two times (2x) improvement as compared to the HBLL architecture.

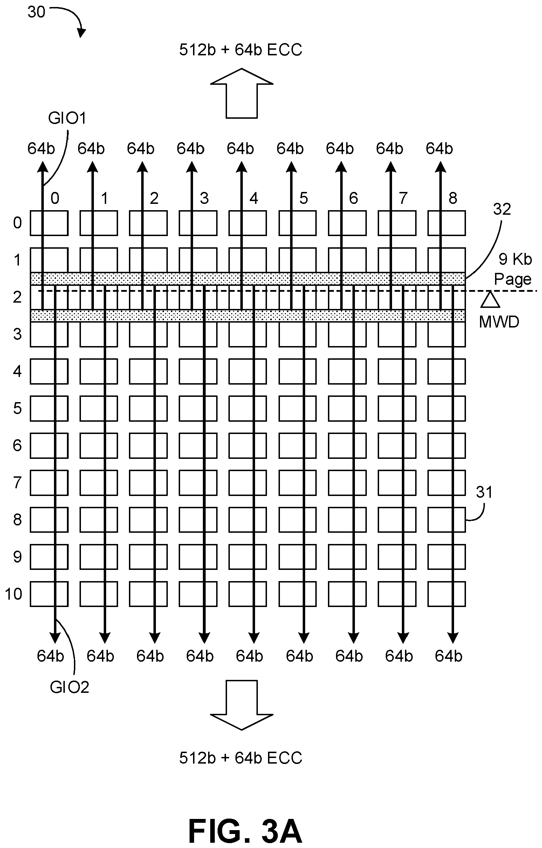

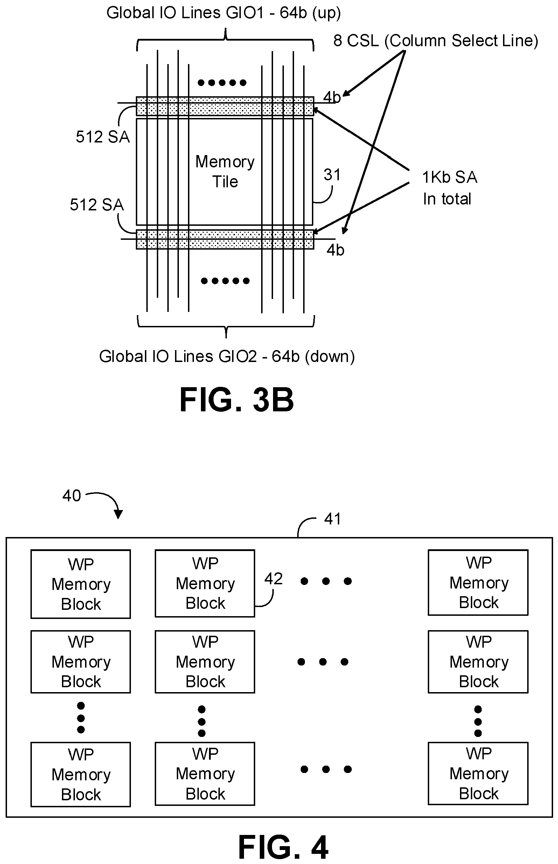

With reference to FIGs. 3A to 3B, an embodiment of an array block 30 may include a matrix of memory tiles 31 nominally arranged in slices 0 through 10 and tile numbers 0 through 8. When a SA is activated, a 9Kb page size may be activated corresponding to tile numbers 0 through 8 for the activated slice (e.g., the SA 32 for slice 2 as illustrated in FIG. 3A is activated by a main write driver (MWD) signal). As shown in FIGs. 3A and 3B, the array block 30 includes double of the global IO lines on the array. For example, each tile number 0 through 9 may include 64 global IO lines GIO1 going from slice 10 to slice 0 (and continuing to a first set of global amplifiers/write drivers) and 64 global IO lines GI02 going from slice 0 to slice 10 (and continuing to a second set of global amplifiers/write drivers) to provide 128 global IO line pairs (e.g., 64 GIO1 lines + 64 GI02 lines = 128 global IO line pairs in total per tile). Those skilled in the art will appreciate that the global IO lines GIO1 and GI02 pass through each slice/row 0 through 10 of the tile number 0 column, and are connected to the appropriate memory tile when the SA for the slice is activated by the MWD signal. As used herein, "on the array" refers routing of the global IO lines coincident with the memory tiles. As shown in FIG. 3B, the global IO lines may be routed on top of the memory tiles with 64 global IO lines routed up and 64 global IO lines routed down for each memory tile.

For any given fabrication technology, the number of global amplifiers/write drivers that may be placed along one side of the array block is limited. For example, for some fabrication technologies it may not be feasible to place 128 global amplifiers/write drivers on one side of the array block. However, those same fabrication technologies may readily place double the amount of global IO lines on the array in accordance with some embodiments. Advantageously, some embodiments double the effective number of global amplifiers/write drivers for the array block 30 by placing global amplifiers/write drivers on opposed sides of the array block 30 (e.g., a set of 64 at the top side in addition to a set of 64 bottom side) with half of the global IO line connected to the set at the bottom side of the array block 30 and the other half of the global IO lines connected to the set at the top side of the array block 30. Utilizing the space between array blocks for more global amplifiers/write drivers increases the die size, but more effective utilization of the memory bandwidth from the provided WP provides some offset in more efficient memory access.

In the illustrated example, for an array block with a 9Kb page size (8Kb data + 1Kb ECC), the array block provides a 512b + 64b ECC prefetch size to a first set of global amplifiers/write drivers plus a 512b + 64b ECC prefetch size to a second set of global amplifiers/write drivers for a total prefetch size of 1024b plus 128b ECC. Advantageously, some embodiments increase the prefetch size two times (2x) as compared to the HBLL architecture, and improve the P:W ratio from 128:1 (e.g., HBM2) or 16:1 (e.g., HBLL) to 8:1. Advantageously, embodiments of a WP DRAM with the larger prefetch size may bring even higher memory bandwidth while keeping the same capacity and lower energy consumption (pJ/bit) with DRAM device technology. Those skilled in the art will appreciate that the 9 x 11 matrix illustrated in FIG. 3A is only one example embodiments. Other embodiments may be readily adapted to other memory tile arrangements as may be suitable for different memory vendors, different memory generations, different DRAM type such as DDR, LPDDR, GDDR and so on, etc.

With reference to FIG. 4, an embodiment of a WP memory device 40 includes a substrate 41 with a plurality of WP memory blocks 42 coupled to the substrate. For example, the substrate 41 may comprise a semiconductor substrate such as a silicon substrate. For example, each of the WP memory blocks 42 may be configured similar to the memory apparatus 10 (FIG. 1) and/or the memory circuit 22 (FIG. 2), with array blocks configured similar to the array block 30 (see FIGs. 3A to 3B). In some embodiments, the WP memory device 40 may include RAM, such as DRAM, and TSVs, and may be configured as a WP DRAM die 40 suitable for stacking in a HBM memory device.

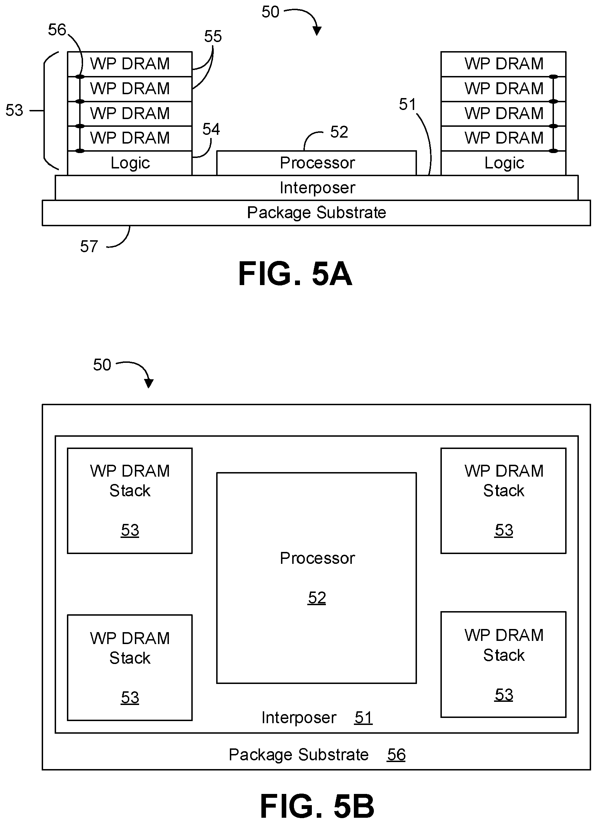

With reference to FIGs. 5A to 5B, an embodiment of an electronic apparatus 50 may include an interposer 51, a processor 52 coupled to the interposer 51, and at least one WP memory stack device 53 coupled to the interposer 51 and communicatively coupled to the processor 52 through the interposer 51. The at least one WP memory stack device 53 may include a stack of dice including at least one logic die 54 and at least two WP memory dice 55. An inter-die connection for the memory dice 55 and/or logic die 54 may be made with through silicon vias (TSVs) 56, for example. The at least two WP memory dice 55 may each comprise a plurality of WP memory blocks (e.g., as described in connection with FIG. 4). In some embodiments, the apparatus 50 may further include a package substrate 57 coupled to the interposer 51. For example, the package substrate 57 may include a SoC package or a printed circuit board such as graphics board, a HPC board, etc.

In accordance with some embodiments, the WP memory blocks of the WP memory dice 55 may each comprise an array block with memory tiles arranged in a matrix along two perpendicular directions, a first set of global amplifiers coupled to the memory tiles and arranged along a first side of the matrix, and a second set of global amplifiers coupled to the memory tiles and arranged along a second side of the matrix opposite to the first side of the matrix. In some embodiments, the WP memory blocks each further comprise a first set of write drivers coupled to the memory tiles and arranged along the first side of the matrix, and a second set of write drivers coupled to the memory tiles and arranged along the second side of the matrix. The WP memory blocks may each further comprise a first set of global IO signals arranged from memory tiles along the second side of the matrix to the first set of global amplifiers, and a second set of global IO signals arranged from memory tiles along the first side of the matrix to the second set of global amplifiers. For example, the WP memory blocks may also each comprise a first subset of the first set of global IO signals respectively coupled to a first memory tile of the matrix and a first subset the first set of global amplifiers, and a first subset of the second set of global IO signals respectively coupled to the first memory tile of the matrix and a first subset of the second set of global amplifiers.

In some embodiments, the matrix comprises an 9 by 11 matrix arranged in a general rectangular shape with 9 memory tiles arranged substantially linearly in a first direction by 11 memory tiles arranged substantially linearly in a second direction substantially perpendicular to the first direction, and the matrix provides a page size of 1 kilobyte of data when activated by an access command. For example, the first and second sets of global IO signals provide a combined prefetch size for the matrix with a data width of at least 1024 bits. In some embodiments, the memory tiles may comprise RAM such as DRAM, and the WP memory dice 55 may be considered WP DRAM 55 and the WP memory stack device 53 may be considered a WP DRAM stack 53.

The technology discussed herein may be provided in various computing systems (e.g., including a non-mobile computing device such as a desktop, workstation, server, rack system, etc., a mobile computing device such as a smartphone, tablet, Ultra-Mobile Personal Computer (UMPC), laptop computer, ULTRABOOK computing device, smart watch, smart glasses, smart bracelet, etc., and/or a client/edge device such as an Internet-of-Things (IoT) device (e.g., a sensor, a camera, etc.)).

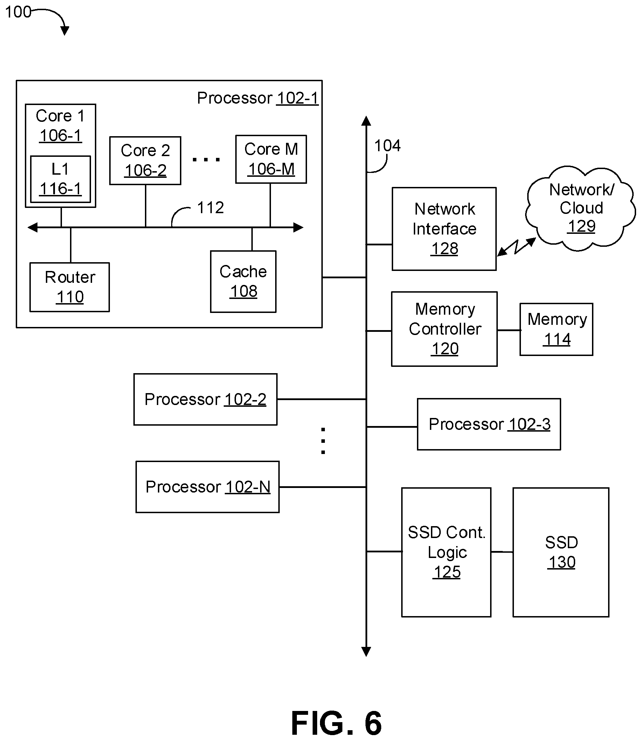

Turning now to FIG. 6, an embodiment of a computing system 100 may include one or more processors 102-1 through 102-N (generally referred to herein as "processors 102" or "processor 102"). The processors 102 may communicate via an interconnection or bus 104. Each processor 102 may include various components some of which are only discussed with reference to processor 102-1 for clarity. Accordingly, each of the remaining processors 102-2 through 102-N may include the same or similar components discussed with reference to the processor 102-1.

In some embodiments, the processor 102-1 may include one or more processor cores 106-1 through 106-M (referred to herein as "cores 106," or more generally as "core 106"), a cache 108 (which may be a shared cache or a private cache in various embodiments), and/or a router 110. The processor cores 106 may be implemented on a single integrated circuit (IC) chip. Moreover, the chip may include one or more shared and/or private caches (such as cache 108), buses or interconnections (such as a bus or interconnection 112), memory controllers, or other components.

In some embodiments, the router 110 may be used to communicate between various components of the processor 102-1 and/or system 100. Moreover, the processor 102-1 may include more than one router 110. Furthermore, the multitude of routers 110 may be in communication to enable data routing between various components inside or outside of the processor 102-1.

The cache 108 may store data (e.g., including instructions) that is utilized by one or more components of the processor 102-1, such as the cores 106. For example, the cache 108 may locally cache data stored in a memory 114 for faster access by the components of the processor 102. As shown in FIG. 6, the memory 114 may be in communication with the processors 102 via the interconnection 104. In some embodiments, the cache 108 (that may be shared) may have various levels, for example, the cache 108 may be a mid-level cache and/or a last-level cache (LLC). Also, each of the cores 106 may include a level 1 (LI) cache (116-1) (generally referred to herein as "L1 cache 116"). Various components of the processor 102-1 may communicate with the cache 108 directly, through a bus (e.g., the bus 112), and/or a memory controller or hub.

As shown in FIG. 6, memory 114 may be coupled to other components of system 100 through a memory controller 120. Memory 114 may include volatile memory and may be interchangeably referred to as main memory. Even though the memory controller 120 is shown to be coupled between the interconnection 104 and the memory 114, the memory controller 120 may be located elsewhere in system 100. For example, memory controller 120 or portions of it may be provided within one of the processors 102 in some embodiments.

The system 100 may communicate with other devices/systems/networks via a network interface 128 (e.g., which is in communication with a computer network and/or the cloud 129 via a wired or wireless interface). For example, the network interface 128 may include an antenna (not shown) to wirelessly (e.g., via an Institute of Electrical and Electronics Engineers (IEEE) 802.11 interface (including IEEE 802.11a/b/g/n/ac, etc.), cellular interface, 3G, 4G, LTE, BLUETOOTH, etc.) communicate with the network/cloud 129.

System 100 may also include a storage device such as a SSD device 130 coupled to the interconnect 104 via SSD controller logic 125. Hence, logic 125 may control access by various components of system 100 to the SSD device 130. Furthermore, even though logic 125 is shown to be directly coupled to the interconnection 104 in FIG. 6, logic 125 can alternatively communicate via a storage bus/interconnect (such as the SATA (Serial Advanced Technology Attachment) bus, Peripheral Component Interconnect (PCI) (or PCI EXPRESS (PCIe) interface), NVM EXPRESS (NVMe), etc.) with one or more other components of system 100 (for example where the storage bus is coupled to interconnect 104 via some other logic like a bus bridge, chipset, etc.) Additionally, logic 125 may be incorporated into memory controller logic or provided on a same integrated circuit (IC) device in various embodiments (e.g., on the same circuit board device as the SSD device 130 or in the same enclosure as the SSD device 130).

Furthermore, logic 125 and/or SSD device 130 may be coupled to one or more sensors (not shown) to receive information (e.g., in the form of one or more bits or signals) to indicate the status of or values detected by the one or more sensors. These sensor(s) may be provided proximate to components of system 100 (or other computing systems discussed herein), including the cores 106, interconnections 104 or 112, components outside of the processor 102, SSD device 130, SSD bus, SATA bus, logic 125, etc., to sense variations in various factors affecting power/thermal behavior of the system/platform, such as temperature, operating frequency, operating voltage, power consumption, and/or inter-core communication activity, etc.

Advantageously, the memory 114, or other memory communicatively coupled to the processors 102, may include technology to implement one or more aspects of the apparatus 10 (FIG. 1), the apparatus 20 (FIG. 2), the array block 30 (FIG. 3A), the memory tiles 31 (FIG. 3B), the device 40 (FIG. 4), or the apparatus 50 (FIG. 5), and/or any of the features discussed herein. For example, the memory 114 may include an embodiment of a HBM compatible DRAM device with a wide prefetch with one or more of the features discussed herein (e.g., double global IO routing, global amplifiers on opposed sides of an array block, etc.).

### Additional Notes and Examples

Example 1 includes an electronic apparatus, comprising a silicon substrate, and a memory circuit coupled to the silicon substrate, the memory circuit including an array block of memory tiles coupled to the silicon substrate, a first set of global amplifiers coupled to the silicon substrate and the memory tiles and arranged along a first side of the array block, and a second set of global amplifiers coupled to the silicon substrate and coupled to the memory tiles and arranged along a second side of the array block opposite to the first side of the array block.
Example 2 includes the apparatus of Example 1, wherein the memory circuit further comprises a first set of global input/output signals coupled to the silicon substrate and arranged on the array from memory tiles along the second side of the array block to the first set of global amplifiers, and a second set of global input/output signals coupled to the silicon substrate and arranged on the array from memory tiles along the first side of the array block to the second set of global amplifiers.
Example 3 includes the apparatus of Example 2, wherein the memory circuit further comprises a first subset of the first set of global input/output signals respectively coupled to a first memory tile of the array block and a first subset the first set of global amplifiers, and a first subset of the second set of global input/output signals respectively coupled to the first memory tile of the array block and a first subset of the second set of global amplifiers.
Example 4 includes the apparatus of any of Examples 2 to 3, wherein the array block comprises an M by N matrix arranged in a general rectangular shape with M memory tiles arranged substantially linearly in a first direction by N memory tiles arranged substantially linearly in a second direction substantially perpendicular to the first direction, and wherein the array block provides a page size of P of data when activated by an access command, where P is greater than or equal to 1 kilobyte.
Example 5 includes the apparatus of Example 4, wherein the first and second sets of global input/output signals provide a combined prefetch size of W bits, and wherein a ratio of P to W is less than or equal to 8 to 1.
Example 6 includes the apparatus of any of Examples 1 to 5, further including a first set of write drivers coupled to the silicon substrate and coupled to the memory tiles and arranged along the first side of the array block, and a second set of write drivers coupled to the silicon substrate and coupled to the memory tiles and arranged along the second side of the array block.
Example 7 includes the apparatus of any of Examples 1 to 6, further comprising a plurality of through silicon vias configured to couple to another substrate.
   Another Example includes the apparatus of any of Examples 1 through 7, wherein the memory tiles comprise random access memory, such as dynamic random access memory.
Example 8 includes a memory apparatus, comprising an array block of memory tiles, a first set of global amplifiers coupled to the memory tiles and arranged along a first side of the array block, and a second set of global amplifiers coupled to the memory tiles and arranged along a second side of the array block opposite to the first side of the array block.
Example 9 includes the apparatus of Example 8, further comprising a first set of global input/output signals arranged from memory tiles along the second side of the array block to the first set of global amplifiers, and a second set of global input/output signals arranged from memory tiles along the first side of the array block to the second set of global amplifiers.
Example 10 includes the apparatus of Example 9, further comprising a first subset of the first set of global input/output signals respectively coupled to a first memory tile of the array block and a first subset the first set of global amplifiers, and a first subset of the second set of global input/output signals respectively coupled to the first memory tile of the array block and a first subset of the second set of global amplifiers.
Example 11 includes the apparatus of any of Examples 9 to 10, wherein the array block comprises an M by N matrix arranged in a general rectangular shape with M memory tiles arranged substantially linearly in a first direction by N memory tiles arranged substantially linearly in a second direction substantially perpendicular to the first direction, and wherein the array block provides a page size of P of data when activated by an access command, where P is greater than or equal to 1 kilobyte.
Example 12 includes the apparatus of Example 11, wherein the first and second sets of global input/output signals provide a combined prefetch size of W bits, and wherein a ratio of P to W is less than or equal to 8 to 1.
Example 13 includes the apparatus of any of Examples 8 to 12, further including a first set of write drivers coupled to the memory tiles and arranged along the first side of the array block, and a second set of write drivers coupled to the memory tiles and arranged along the second side of the array block.
Example 14 includes the apparatus of any of Examples 8 to 13, wherein the memory tiles comprise random access memory, such as dynamic random access memory.
Example 15 includes an electronic apparatus, comprising an interposer, a processor coupled to the interposer, and at least one wide prefetch memory stack device coupled to the interposer and communicatively coupled to the processor through the interposer, the at least one wide prefetch memory stack device including a stack of dice including at least one logic die and at least two wide prefetch memory dice, wherein the at least two wide prefetch memory dice each comprise a plurality of wide prefetch memory blocks, and wherein the wide prefetch memory blocks each comprise an array block with memory tiles arranged in a matrix along two perpendicular directions, a first set of global amplifiers coupled to the memory tiles and arranged along a first side of the matrix, and a second set of global amplifiers coupled to the memory tiles and arranged along a second side of the matrix opposite to the first side of the matrix.
Example 16 includes the apparatus of Example 15, wherein the wide prefetch memory blocks each further comprise a first set of global input/output signals arranged from memory tiles along the second side of the matrix to the first set of global amplifiers, and a second set of global input/output signals arranged from memory tiles along the first side of the matrix to the second set of global amplifiers.
Example 17 includes the apparatus of Example 16, wherein the wide prefetch memory blocks each further comprise a first subset of the first set of global input/output signals respectively coupled to a first memory tile of the matrix and a first subset the first set of global amplifiers, and a first subset of the second set of global input/output signals respectively coupled to the first memory tile of the matrix and a first subset of the second set of global amplifiers.
Example 18 includes the apparatus of any of Examples 16 to 17, wherein the matrix comprises an 9 by 11 matrix arranged in a general rectangular shape with 9 memory tiles arranged substantially linearly in a first direction by 11 memory tiles arranged substantially linearly in a second direction substantially perpendicular to the first direction, and wherein the matrix provides a page size of 1 kilobyte of data when activated by an access command.
Example 19 includes the apparatus of Example 18, wherein the first and second sets of global input/output signals provide a combined prefetch size for the matrix with a data width of at least 1024 bits.
Example 20 includes the apparatus of any of Examples 15 to 19, wherein the wide prefetch memory blocks each further comprise a first set of write drivers coupled to the memory tiles and arranged along the first side of the matrix, and a second set of write drivers coupled to the memory tiles and arranged along the second side of the matrix.
Example 21 includes the apparatus of any of Examples 15 to 20, wherein the memory tiles comprise dynamic random access memory.
Example 22 includes a method of increasing memory bandwidth, comprising providing an array block of memory tiles, providing a first set of global amplifiers coupled to the memory tiles and arranged along a first side of the array block, and providing a second set of global amplifiers coupled to the memory tiles and arranged along a second side of the array block opposite to the first side of the array block.
Example 23 includes the method of Example 22, further comprising providing a first set of write drivers coupled to the memory tiles and arranged along the first side of the array block, and providing a second set of write drivers coupled to the memory tiles and arranged along the second side of the array block.
Example 24 includes the method of Example 22, further comprising providing a first set of global input/output signals arranged from memory tiles along the second side of the array block to the first set of global amplifiers, and providing a second set of global input/output signals arranged from memory tiles along the first side of the array block to the second set of global amplifiers.
Example 25 includes the method of Example 24, further comprising providing a first subset of the first set of global input/output signals respectively coupled to a first memory tile of the array block and a first subset the first set of global amplifiers, and providing a first subset of the second set of global input/output signals respectively coupled to the first memory tile of the array block and a first subset of the second set of global amplifiers.
Example 26 includes the method of any of Examples 24 to 25, wherein the array block comprises an M by N matrix arranged in a general rectangular shape with M memory tiles arranged substantially linearly in a first direction by N memory tiles arranged substantially linearly in a second direction substantially perpendicular to the first direction, and wherein the array block provides a page size of P of data when activated by an access command, where P is greater than or equal to 1 kilobyte.
Example 27 includes the method of Example 26, wherein the first and second sets of global input/output signals provide a combined prefetch size of W bits, and wherein a ratio of P to W is less than or equal to 8 to 1.
Example 28 includes the method of any of Examples 22 to 27, wherein the memory tiles comprise random access memory.
Example 29 includes the method of any of Examples 22 to 28, wherein the memory tiles comprise dynamic random access memory.
Example 30 includes a memory apparatus, comprising means for providing an array block of memory tiles, means for providing a first set of global amplifiers coupled to the memory tiles and arranged along a first side of the array block, and means for providing a second set of global amplifiers coupled to the memory tiles and arranged along a second side of the array block opposite to the first side of the array block.
Example 31 includes the apparatus of Example 30, further comprising means for providing a first set of write drivers coupled to the memory tiles and arranged along the first side of the array block, and means for providing a second set of write drivers coupled to the memory tiles and arranged along the second side of the array block.
Example 32 includes the apparatus of Example 30, further comprising means for providing a first set of global input/output signals arranged from memory tiles along the second side of the array block to the first set of global amplifiers, and means for providing a second set of global input/output signals arranged from memory tiles along the first side of the array block to the second set of global amplifiers.
Example 33 includes the apparatus of Example 32, further comprising means for providing a first subset of the first set of global input/output signals respectively coupled to a first memory tile of the array block and a first subset the first set of global amplifiers, and means for providing a first subset of the second set of global input/output signals respectively coupled to the first memory tile of the array block and a first subset of the second set of global amplifiers.
Example 34 includes the apparatus of any of Examples 32 to 33, wherein the array block comprises an M by N matrix arranged in a general rectangular shape with M memory tiles arranged substantially linearly in a first direction by N memory tiles arranged substantially linearly in a second direction substantially perpendicular to the first direction, and wherein the array block provides a page size of P of data when activated by an access command, where P is greater than or equal to 1 kilobyte.
Example 35 includes the apparatus of Example 34, wherein the first and second sets of global input/output signals provide a combined prefetch size of W bits, and wherein a ratio of P to W is less than or equal to 8 to 1.
Example 36 includes the apparatus of any of Examples 30 to 35, wherein the memory tiles comprise random access memory.
Example 37 includes the apparatus of any of Examples 30 to 36, wherein the memory tiles comprise dynamic random access memory.

The term "coupled" may be used herein to refer to any type of relationship, direct or indirect, between the components in question, and may apply to electrical, mechanical, fluid, optical, electromagnetic, electromechanical or other connections. In addition, the terms "first", "second", etc. may be used herein only to facilitate discussion, and carry no particular temporal or chronological significance unless otherwise indicated.

As used in this application and in the claims, a list of items joined by the term "one or more of' may mean any combination of the listed terms. For example, the phrase "one or more of A, B, and C" and the phrase "one or more of A, B, or C" both may mean A; B; C; A and B; A and C; B and C; or A, B and C. Various components of the systems described herein may be implemented in software, firmware, and/or hardware and/or any combination thereof. For example, various components of the systems or devices discussed herein may be provided, at least in part, by hardware of a computing SoC such as may be found in a computing system such as, for example, a smart phone. Those skilled in the art may recognize that systems described herein may include additional components that have not been depicted in the corresponding figures. For example, the systems discussed herein may include additional components such as bit stream multiplexer or de-multiplexer modules and the like that have not been depicted in the interest of clarity.

While implementation of the example processes discussed herein may include the undertaking of all operations shown in the order illustrated, the present disclosure is not limited in this regard and, in various examples, implementation of the example processes herein may include only a subset of the operations shown, operations performed in a different order than illustrated, or additional operations.

In addition, any one or more of the operations discussed herein may be undertaken in response to instructions provided by one or more computer program products. Such program products may include signal bearing media providing instructions that, when executed by, for example, a processor, may provide the functionality described herein. The computer program products may be provided in any form of one or more machine-readable media. Thus, for example, a processor including one or more graphics processing unit(s) or processor core(s) may undertake one or more of the blocks of the example processes herein in response to program code and/or instructions or instruction sets conveyed to the processor by one or more machine-readable media. In general, a machine-readable medium may convey software in the form of program code and/or instructions or instruction sets that may cause any of the devices and/or systems described herein to implement at least portions of the operations discussed herein and/or any portions the devices, systems, or any module or component as discussed herein.

As used in any implementation described herein, the term "module" refers to any combination of software logic, firmware logic, hardware logic, and/or circuitry configured to provide the functionality described herein. The software may be embodied as a software package, code and/or instruction set or instructions, and "hardware", as used in any implementation described herein, may include, for example, singly or in any combination, hardwired circuitry, programmable circuitry, state machine circuitry, fixed function circuitry, execution unit circuitry, and/or firmware that stores instructions executed by programmable circuitry. The modules may, collectively or individually, be embodied as circuitry that forms part of a larger system, for example, an integrated circuit (IC), system on-chip (SoC), and so forth.

Various embodiments may be implemented using hardware elements, software elements, or a combination of both. Examples of hardware elements may include processors, microprocessors, circuits, circuit elements (e.g., transistors, resistors, capacitors, inductors, and so forth), integrated circuits, application specific integrated circuits (ASIC), programmable logic devices (PLD), digital signal processors (DSP), field programmable gate array (FPGA), logic gates, registers, semiconductor device, chips, microchips, chip sets, and so forth. Examples of software may include software components, programs, applications, computer programs, application programs, system programs, machine programs, operating system software, middleware, firmware, software modules, routines, subroutines, functions, methods, procedures, software interfaces, application program interfaces (API), instruction sets, computing code, computer code, code segments, computer code segments, words, values, symbols, or any combination thereof. Determining whether an embodiment is implemented using hardware elements and/or software elements may vary in accordance with any number of factors, such as desired computational rate, power levels, heat tolerances, processing cycle budget, input data rates, output data rates, memory resources, data bus speeds and other design or performance constraints.

One or more aspects of at least one embodiment may be implemented by representative instructions stored on a machine-readable medium which represents various logic within the processor, which when read by a machine causes the machine to fabricate logic to perform the techniques described herein. Such representations, known as IP cores may be stored on a tangible, machine readable medium and supplied to various customers or manufacturing facilities to load into the fabrication machines that actually make the logic or processor.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the embodiments are not limited to the embodiments so described, but can be practiced with modification and alteration without departing from the scope of the appended claims. For example, the above embodiments may include specific combination of features. However, the above embodiments are not limited in this regard and, in various implementations, the above embodiments may include the undertaking only a subset of such features, undertaking a different order of such features, undertaking a different combination of such features, and/or undertaking additional features than those features explicitly listed. The scope of the embodiments should, therefore, be determined with reference to the appended claims, along with the full scope of equivalents to which such claims are entitled.

## Claims

1. An electronic apparatus, comprising:
a silicon substrate; and
a memory circuit coupled to the silicon substrate, the memory circuit including:
an array block of memory tiles coupled to the silicon substrate,
a first set of global amplifiers coupled to the silicon substrate and the memory tiles and arranged along a first side of the array block,
a first set of write drivers coupled to the silicon substrate and coupled to the memory tiles and arranged along the first side of the array block,
a second set of global amplifiers coupled to the silicon substrate and coupled to the memory tiles and arranged along a second side of the array block opposite to the first side of the array block, and
a second set of write drivers coupled to the silicon substrate and coupled to the memory tiles and arranged along the second side of the array block.

2. The apparatus of claim 1, wherein the memory circuit further comprises:
a first set of global input/output signals coupled to the silicon substrate and arranged on the array from memory tiles along the second side of the array block to the first set of global amplifiers; and
a second set of global input/output signals coupled to the silicon substrate and arranged on the array from memory tiles along the first side of the array block to the second set of global amplifiers.

3. The apparatus of claim 2, wherein the memory circuit further comprises:
a first subset of the first set of global input/output signals respectively coupled to a first memory tile of the array block and a first subset the first set of global amplifiers; and
a first subset of the second set of global input/output signals respectively coupled to the first memory tile of the array block and a first subset of the second set of global amplifiers.

4. The apparatus of any of claims 2 to 3, wherein the array block comprises an M by N matrix arranged in a general rectangular shape with M memory tiles arranged substantially linearly in a first direction by N memory tiles arranged substantially linearly in a second direction substantially perpendicular to the first direction, and wherein the array block provides a page size of P of data when activated by an access command, where P is greater than or equal to 1 kilobyte.

5. The apparatus of claim 4, wherein the first and second sets of global input/output signals provide a combined prefetch size of W bits, and wherein a ratio of P to W is less than or equal to 8 to 1.

6. An electronic apparatus, comprising:
an interposer
a processor coupled to the interposer; and
at least one wide prefetch memory stack device coupled to the interposer and communicatively coupled to the processor through the interposer, the at least one wide prefetch memory stack device including a stack of dice including at least one logic die and at least two wide prefetch memory dice, wherein the at least two wide prefetch memory dice each comprise a plurality of wide prefetch memory blocks, and wherein the wide prefetch memory blocks each comprise:
an array block with memory tiles arranged in a matrix along two perpendicular directions;
a first set of global amplifiers coupled to the memory tiles and arranged along a first side of the matrix; and
a second set of global amplifiers coupled to the memory tiles and arranged along a second side of the matrix opposite to the first side of the matrix.

7. The apparatus of claim 6, wherein the wide prefetch memory blocks each further comprise:
a first set of global input/output signals arranged from memory tiles along the second side of the matrix to the first set of global amplifiers; and
a second set of global input/output signals arranged from memory tiles along the first side of the matrix to the second set of global amplifiers.

8. The apparatus of claim 7, wherein the wide prefetch memory blocks each further comprise:
a first subset of the first set of global input/output signals respectively coupled to a first memory tile of the matrix and a first subset the first set of global amplifiers; and
a first subset of the second set of global input/output signals respectively coupled to the first memory tile of the matrix and a first subset of the second set of global amplifiers.

9. The apparatus of any of claims 7 to 8, wherein the matrix comprises an 9 by 11 matrix arranged in a general rectangular shape with 9 memory tiles arranged substantially linearly in a first direction by 11 memory tiles arranged substantially linearly in a second direction substantially perpendicular to the first direction, and wherein the matrix provides a page size of 1 kilobyte of data when activated by an access command.

10. The apparatus of claim 9, wherein the first and second sets of global input/output signals provide a combined prefetch size for the matrix with a data width of at least 1024 bits.

11. The apparatus of claim 6, wherein the wide prefetch memory blocks each further comprise:
a first set of write drivers coupled to the memory tiles and arranged along the first side of the matrix; and
a second set of write drivers coupled to the memory tiles and arranged along the second side of the matrix.

12. A method of increasing memory bandwidth, comprising:
providing an array block of memory tiles;
providing a first set of global amplifiers coupled to the memory tiles and arranged along a first side of the array block; and
providing a second set of global amplifiers coupled to the memory tiles and arranged along a second side of the array block opposite to the first side of the array block.

13. The method of claim 12, further comprising:
providing a first set of write drivers coupled to the memory tiles and arranged along the first side of the array block; and
providing a second set of write drivers coupled to the memory tiles and arranged along the second side of the array block.

14. The method of claim 12, further comprising:
providing a first set of global input/output signals arranged from memory tiles along the second side of the array block to the first set of global amplifiers; and
providing a second set of global input/output signals arranged from memory tiles along the first side of the array block to the second set of global amplifiers.

15. The method of claim 14, further comprising:
providing a first subset of the first set of global input/output signals respectively coupled to a first memory tile of the array block and a first subset the first set of global amplifiers; and
providing a first subset of the second set of global input/output signals respectively coupled to the first memory tile of the array block and a first subset of the second set of global amplifiers.
